# EUROPEAN PATENT APPLICATION

(11) **EP 4 391 028 A1**
(43) Date of publication of application: **26.06.2024**
(21) Application number: 22383282.5
(22) Date of filing: 23.12.2022
(51) Int. Cl.: H01L 21/336, H01L 29/16

(54) **GRAPHENE DEVICE AND METHOD OF FABRICATING A GRAPHENE DEVICE**

(71) Applicant: Graphenea Semiconductor S.L.U., 20009 Donostia - San Sebastian, Guipuzcoa (ES)
(72) Inventor: TORRES ALONSO, Elías, Donostia - San Sebastián (Guipúzcoa) (ES)
(74) Representative: Balder IP Law, S.L.

(57) **Abstract**

A method of fabricating a graphene-based solid-state device comprises: disposing a graphene layer (101) on a substrate (100); depositing a sacrificial layer (102) on the graphene layer (101), the sacrificial layer (102) being made of a non-polymeric dielectric material; patterning the graphene layer (101) by defining at least one channel region, wherein the patterning is done by applying a lithographic process followed by an etching process using a resist layer, thus obtaining a patterned graphene layer (101'), wherein the graphene layer (101') has been protected against contamination from the resist layer by the sacrificial layer (102); patterning on the graphene layer (101') a geometry of at least one metallic contact to be deposited; depositing the at least one metallic contact (107') on the graphene layer (101'). A graphene-based solid-state device comprises: a substrate (100); a graphene layer (101) disposed on the substrate (100), the graphene layer (101) defining at least one graphene channel; the graphene layer (101) being protected by a sacrificial layer (102) made of a non-polymeric dielectric material; at least one metallic contact (107') in contact with the graphene channel.

## Description

### TECHNICAL FIELD

The present invention relates to the field of semiconductors and electronics industry and, in particular, to graphene-based solid-state devices and associated methods.

### STATE OF THE ART

Since its discovery at the beginning of the 21^{st} century, graphene has attracted much attention due to its properties, such as high electronic mobility, low density of states and low charge density. These properties make graphene an ideal material in a myriad of electronic applications, such as RF devices, magnetic sensors, biosensors and photodetectors, among others.

In particular, the monolayer structure of graphene allows it to be sensitive to electrostatic perturbations at its surface. The observation of this sensitivity has enabled the development of graphene solid-state devices, such as diodes, transistors and thyristors, which, when for example used as chemical and biological sensors, their electrical properties change when exposed to a targeted chemical or biological agent.

However, when fabricating graphene devices, these attributes are usually not observed due to contamination in the form of impurities, residues and defects introduced during the processing of the graphene films to obtain the graphene devices. These defects characterize not only graphene, but in general other carbon-based materials, such as CNT and Fullerenes, among others.

The major cause of contamination in these devices is introduced in the form of polymeric contamination, mainly due to the photoresists used during processing. This reduces the quality of the metallic contact subsequently deposited, and thus increases contact resistance, resulting in poor carrier injection, and degrades electron mobility in the channel due to scattering caused by the polymeric residues and impurities.

Moreover, when creating the contact pattern via photoresist prior to metal deposition, the graphene is in contact with strong bases used in the photoresist development and lithographic processing in general. This causes graphene detachment, reducing the contact area and decreasing the carrier injection again.

For example, US8878193B2 discloses methods for fabricating graphene channel-based devices, in which to pattern the graphene, the graphene is in touch with a photoresist made of PMMA, causing the problems abovementioned. Similarly, in US8895417B2, to pattern the graphene, the graphene is in touch with a polymeric dielectric, such as PMMA or HSQ, which contaminates the graphene.

An existing approach to protect the graphene against polymeric contamination is based on bottom contacts. However, these contacts usually render poor yield due to, among other reasons, the abovementioned detachment, and thus poor carrier injection. For example, US8796096B2 discloses a method of fabricating a graphene-based semiconductor device having bottom, suspended contacts, which render poor carrier injection and low yield. Besides, the disclosed structure requires multiple metallization steps.

Another problem inherent to graphene-based devices is that the metal contacts are conventionally defined at the edges of the graphene channel. This involves very demanding alignment tolerances and large exposure of the graphene channel edges to the photoresist developers.

Therefore, there is a need to develop new methods of fabricating graphene-based solid-state devices which overcome the above-mentioned drawbacks.

### DESCRIPTION OF THE INVENTION

The present invention provides a new graphene-based solid-state device and a new method of fabricating a graphene-based solid-state device. In the proposed method, direct interaction or contact between the graphene and photopolymers and developers is prevented. Thus, contamination of the graphene channel is prevented. The graphene-based solid-state device can be, for example, a graphene-based transistor, such as a graphene-based field effect transistor (GFET).

The proposed fabrication method includes a stage of metallizing a solid-state device (SSD) (also referred to as semiconductor device) comprising graphene. Semiconductor devices are based on a semiconductor material, such as silicon, germanium, gallium arsenide or an organic semiconductor. Current flow in a semiconductor occurs due to mobility of free electrons, also called charge carriers. The graphene-based solid-state device can be any solid-state device in which the semiconductor material is graphene, for example a graphene channel. The graphene-based semiconductor device fabricated following the proposed method and to which the proposed metallization process is applicable can be a single-terminal device, such as an electromagnetic shield, or a two-terminal device, such as a diode, or a three-terminal device, such as a transistor, or an N-terminal device, such as a device built for transmission length method (TLM) measurements. The graphene-based semiconductor device is preferably a device having two or more terminals. Non-limiting examples of graphene-based solid-state devices to which the metallization process is applicable are: diodes, triodes, bipolar junction transistors, field-effect transistors, metal-oxide semiconductors, High-electron mobility transistors (HEMTs), thyristors, barristors, memristors, varactors, pn junctions, pin junctions, light emitting diodes, photodetectors, magnetoresistive devices, spin valves, spin torque devices, bolometers and hybrid transition metal dichalcogenide/graphene based heterostructures, among others.

The method involves patterning the graphene channel(s) and/or the metal depositions. In the context of the present invention, patterning involves stages of resist deposition, mask exposure and development. The patterns (geometric shape or profile) of the graphene channel(s) and/or metallic depositions to be applied to the graphene SSD have been previously designed with computer-aided techniques, such as CAD software or the like. The computer-aided design permits to define areas or regions on the surface of the die over which graphene channel(s) are to be defined and/or metallization is to be deposited. Conventional patterning processes cause contamination, mainly polymeric contamination, for example due to the photoresists used during processing. The proposed method prevents this contamination by passivating the graphene layer(s) with a sacrificial layer during the whole fabrication process.

The metallization process is aimed at creating one or more electrical contacts in the graphene device: for example, one contact to enable a subsequent connection to an electric negative pole (of, for example, a voltage source) and another contact to enable a corresponding subsequent connection to an electric positive pole (of, for example, the voltage source).

In a first aspect of the present invention, a method of fabricating a graphene-based solid-state device is provided. The method comprises: disposing a graphene layer on a substrate; depositing a sacrificial layer on the graphene layer, the sacrificial layer being made of a non-polymeric dielectric material; patterning the graphene layer by defining at least one channel region, wherein the patterning is done by applying a lithographic process followed by an etching process using a resist layer, thus obtaining a patterned graphene layer, wherein the graphene layer has been protected against contamination from the resist layer by the sacrificial layer; patterning on the graphene layer (which is protected by the sacrificial layer) a geometry of at least one metallic contact to be deposited; depositing the at least one metallic contact on the graphene layer.

In embodiments of the invention, the substrate is made of a material comprising at least one of the following: glass, quartz, silicon (Si), germanium (Ge), silicon carbide, silicon oxide, gallium arsenide, SiO2/Si, SiO2, Al2O3, ZrO2, HfO2, HfSiO4, Ta2O5, La2O3, LaAIO3, Nb2O5, TiO2, BaTiO3, SrTiO3, CaCu3Ti4O12, Si3N4, ZrSiO4, Y2O3, CaO, MgO, BaO, WO3, MoO3, Sc2O3, Li2O and SrO.

In embodiments of the invention, the substrate is formed by two layers, wherein one of the layers is made of one of silicon, silicon oxide, glass, quartz and polymeric material; and the other layer is made of one of glass, quartz, Si, SiO2/Si, SiO2, Al2O3, ZrO2, HfO2, HfSiO4, Ta2O5, La2O3, LaAIO3, Nb2O5, TiO2, BaTiO3, SrTiO3, CaCu3Ti4O12, Si3N4, ZrSiO4, Y2O3, CaO, MgO, BaO, WO3, MoO3, Sc2O3, Li2O and SrO.

In some embodiments, the substrate is a sacrificial substrate, meaning that a graphene device may be fabricated on the sacrificial substrate and then transferred to another substrate. Any suitable substrate material may be used as sacrificial substrate, providing the substrate material is compatible with the different fabrication steps.

In embodiments of the invention, prior to disposing the at least one graphene layer on the substrate, the substrate is cleaned to remove impurities and increase hydrophilicity.

In embodiments of the invention, the at least one graphene layer is deposited, transferred or grown on the substrate.

In embodiments of the invention, the sacrificial layer is deposited using atomic layer deposition (ALD), chemical vapor deposition (CVP), atomic layer deposition (ALD), chemical vapor deposition (CVD), Vapour Phase Epitaxy, sputtering or Molecular Beam Epitaxy (MBE).

In embodiments of the invention, the thickness of the sacrificial layer is selected to be between 1Å and 100µm.

In embodiments of the invention, the non-polymeric dielectric material of which the sacrificial layer is made is an inorganic oxide. In embodiments of the invention, the inorganic oxide is selected from the following: SiO2, Al2O3, ZrO2, HfO2, HfSiO4, Ta2O5, La2O3, LaAIO3, Nb2O5, TiO2, BaTiO3, SrTiO3, CaCu3Ti4O12, GaN, TaN, Si3N4, ZrSiO4, Y2O3, CaO, MgO, BaO, WO3, MoO3, Sc2O3, Li2O and SrO.

In embodiments of the invention, the patterning of the at least one graphene channel is done as follows: applying a wet etching technique to dissolve the area of the sacrificial layer not covered by resist layer, exposing the graphene layer(s) underneath; applying a dry etching technique to remove the area of graphene layer(s) not covered by the stack formed by sacrificial layer and resist layer.

In embodiments of the invention, the patterning of the at least one graphene channel is done as follows: applying a dry etching technique to remove both the area of the sacrificial layer and the graphene layer(s) underneath not covered by resist layer.

In embodiments of the invention, the patterning on the graphene layer of the geometry of the at least one metallic contact to be deposited is done as follows: depositing a mask layer on the graphene layer, creating an inverse pattern in the mask layer by removing the mask layer in the selected areas where the metal is to be deposited, and leaving the mask layer in the regions to be protected.

In embodiments of the invention, the at least one metallic contact is deposited as follows: applying a metallic layer, lifting off the remaining mask layer, thus removing the metal deposited on the remaining mask layer, so that the at least one metallic contact remains only in the regions where metal has a direct contact with the graphene layer.

In embodiments of the invention, the geometry of the at least one metallic contact to be deposited is patterned within the graphene channel and separate from the lateral sides of the graphene channel.

In a second aspect of the present invention, a graphene-based solid-state device is provided. It comprises a substrate; a graphene layer disposed on the substrate, the graphene layer defining at least one graphene channel; the graphene layer being protected by a sacrificial layer made of a non-polymeric dielectric material; at least one metallic contact in contact with the graphene channel.

The proposed method is especially suitable for the application of top-contact metallization to the graphene-based solid-state device. It is also suitable for graphene-based solid-state devices having both top contacts and edge contacts.

The major cause of contamination in the graphene device, typically introduced in the form of polymeric contamination, mainly due to the resists in the patterning process, is prevented because the graphene layer is always protected by a non-contaminating dielectric made of an inorganic oxide. Thus, the quality of the metallic contact is increased (for example, the contact resistance is reduced), resulting in improved carrier injection and electron mobility.

In addition, when the metallic contacts (such as drain and source contacts when the device is a GFET) are defined and built within the graphene channel, instead of at the lateral sides thereof, such as in the sides (perimeter) of the graphene delimiting with, for example, the substrate, as is the case in standard contact schemes, the alignment tolerance is relaxed, because the lateral sides of the graphene channel can be extended as much as needed without altering the actual length or width of the device. This also avoids large lateral side exposure of the photoresist developers that can cause detachment of the graphene film, deteriorating the quality of the contact. In sum, this contact geometry prevents misalignment problems and graphene detachment.

Additional advantages and features of the invention will become apparent from the detailed description that follows and will be particularly pointed out in the appended claims.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 illustrates a cross-section view of a substrate, according to embodiments of the invention.
Figure 2 illustrates a cross-section view of a graphene film deposited on the substrate, according to embodiments of the invention.
Figure 3A illustrates a cross-section view of a sacrificial layer deposited on the graphene layer, according to embodiments of the invention. Figure 3B illustrates a cross-section view of a resist layer deposited on the sacrificial layer, according to embodiments of the invention.
Figure 4A-4B illustrate cross-section views of stages of a lithographic process used to define the graphene channel(s), according to embodiments of the invention.
Figure 5 illustrates a cross-section view of an alternative lithographic process used to define the graphene channel(s), according to embodiments of the invention.
Figure 6 illustrates a cross-section view of the graphene structure once the graphene channels have been defined and the resist layer has been removed, according to embodiments of the invention.
Figures 7A-7B illustrate a lithographic process used to define the contact area on which metal will be subsequently deposited, according to embodiments of the invention.
Figure 8 illustrates an etching process to expose the graphene area to be subsequently contacted by a metallic deposition, according to embodiments of the invention.
Figure 9 illustrates a cross-section view of a metallic layer deposited over the die, covering the mask layer and the exposed graphene areas, according to embodiments of the invention.
Figure 10 illustrates a cross-section view of the graphene structure after the removal of the mask layer, lifting off the metal on the top of the mask layer, and the remaining deposited metal only in the regions where it has a direct contact with the graphene channel, according to embodiments of the invention.
Figure 11 illustrates a cross-section view of the removal of the encapsulation (sacrificial layer), according to embodiments of the invention.
Figures 12A-12F illustrate top and cross-section views of a graphene structure obtained during the fabrication stages of a graphene device using a standard contact approach, in which the contact areas to receive metal depositions are defined at the lateral areas of the graphene channel.
Figures 13A-13F illustrate top and cross-section views of a graphene structure obtained during the fabrication stages of a graphene device using the proposed contact approach, in which the contact areas to receive metal depositions are defined within the graphene channel.

### DESCRIPTION OF A WAY OF CARRYING OUT THE INVENTION

The following description is not to be taken in a limiting sense but is given solely for the purpose of describing the broad principles of the invention. Next embodiments of the invention will be described by way of example, with reference to the above-mentioned drawings showing apparatuses and results according to the invention.

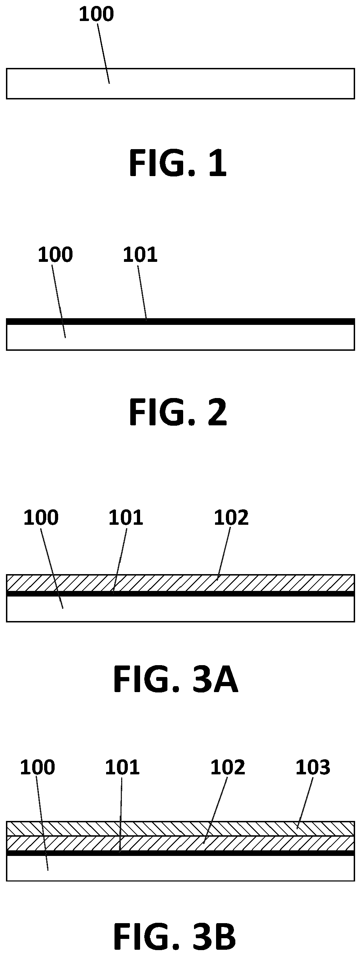

Figures 1-11 schematically represent the fabrication process of a solid-state device comprising graphene, implemented in an electronic die or wafer (not shown), according to embodiments of the invention. The fabrication process includes a metallization process required to deposit at least one electric conductive material to be in contact with the graphene channel.

In accordance with some embodiments of the invention, a graphene device is provided. The fabrication process of the graphene device is explained in detail next.

The substrate 100 is shown in Figure 1. The substrate 100 may comprise a semiconductor and/or an insulating material. Any substrate compatible with the different steps for fabricating a graphene device, can be used. The substrate 100 may be rigid or flexible. The substrate 100 is cleaned, for example via plasma ashing, to remove impurities and increase hydrophilicity. This is done prior to the deposition or growing of the graphene layer. Examples of semiconductor and insulating materials that may be used are glass, quartz, silicon (Si), germanium (Ge), silicon carbide, silicon oxide, gallium arsenide, SiO2/Si, SiO2, Al2O3, ZrO2, HfO2, HfSiO4, Ta2O5, La2O3, LaAIO3, Nb2O5, TiO2, BaTiO3, SrTiO3, CaCu3Ti4O12, Si3N4, ZrSiO4, Y2O3, CaO, MgO, BaO, WO3, MoO3, Sc2O3, Li2O or SrO. In embodiments of the invention, the substrate may be formed by two layers (upper layer and lower layer). The lower layer may be made of one of silicon, silicon oxide, glass, quartz and polymeric material. The higher layer may be made, for example, of glass, quartz, Si, SiO2/Si, SiO2, Al2O3, ZrO2, HfO2, HfSiO4, Ta2O5, La2O3, LaAIO3, Nb2O5, TiO2, BaTiO3, SrTiO3, CaCu3Ti4O12, Si3N4, ZrSiO4, Y2O3, CaO, MgO, BaO, WO3, MoO3, Sc2O3, Li2O or SrO. For example, the substrate may be formed by a silicon dioxide layer deposited on a silicon substrate layer, in turn obtained from doped silica (n++Si).

In some embodiments, the substrate 100 is a sacrificial substrate, meaning that a graphene device may be fabricated on the sacrificial substrate and then transferred to another substrate. Any suitable substrate material may be used as sacrificial substrate, providing the substrate material is compatible with the different fabrication steps.

In Figure 2, a graphene layer 101 is deposited, transferred or grown on the substrate 100. The graphene layer 101 is deposited or grown on the substrate 100 by any conventional process of deposition, transfer or growing of graphene, such as by transfer of CVD graphene layer(s). The deposition/transfer/growing process is out of the scope of the present invention. Preferably, a graphene deposition, transfer or growing process which does not involve the graphene to be in contact with a polymer, is used. The graphene will be configured to serve as active channel or channels of one or more solid-state device, such as one or more transistors.

A sacrificial layer 102 is then deposited on the graphene layer 101. Sacrificial layer 102 is intended to protect the graphene layer from contamination, in particular from polymeric contamination which occurs in the process of patterning the graphene channel mainly due to the required resists. In other words, the sacrificial layer 102 prevents the graphene layer 101 from acquiring any contamination during the subsequent stages of fabrication process of the device, so that the cleaning degree of the graphene in the final device is maintained as it was prior to depositing the sacrificial layer 102. Sacrificial layer 102 is made of a non-polymeric dielectric material (i.e. a non-contaminating dielectric material). The dielectric material is preferably an inorganic oxide. The material of the sacrificial layer 102 is selected to be compatible with different stages of the fabrication of the graphene device. Non-limiting examples of inorganic oxide dielectric materials used for the sacrificial layer 102 are: SiO2, Al2O3, ZrO2, HfO2, HfSiO4, Ta2O5, La2O3, LaAIO3, Nb2O5, TiO2, BaTiO3, SrTiO3, CaCu3Ti4O12, GaN, TaN, Si3N4, ZrSiO4, Y2O3, CaO, MgO, BaO, WO3, MoO3, Sc2O3, Li2O and SrO. The sacrificial layer 102 is made of a material different from a polymeric material to protect the graphene layer against polymeric contamination.

The sacrificial layer 102 may be deposited using a suitable deposition method, such as atomic layer deposition (ALD), chemical vapor deposition (CVD), Vapour Phase Epitaxy, sputtering or Molecular Beam Epitaxy (MBE). The suitability of deposition techniques may depend on the material to be deposited. For example, ALD may be suitable to deposit certain materials, while it may be unsuitable to deposit other materials. A skilled person in the art will select a suitable deposition technique for a selected sacrificial material, preferably inorganic oxide. The thickness of the sacrificial layer 102 may be from several angstrom (10⁻¹⁰m) (for example, from 1Å) to several microns (for example, to 100µm). The thickness is selected taking into account different aspects.

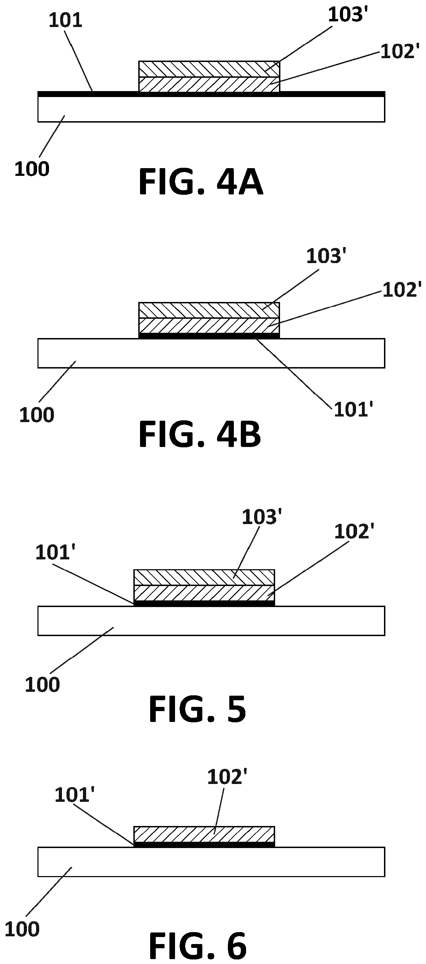

Because the graphene is intended to serve as active channel or channels of one or more solid-state devices, the next step in the fabrication process is to pattern the graphene layer(s) with the layout of the channel(s). Figure 4-11 illustrate cross-section views of stages involved in patterning metal contacts and subsequent depositing the metal contacts, according to an embodiment of the present invention. The graphene layer(s) are patterned to define one or more structures, such as one or more channel regions of a graphene device (e.g. a transistor) to be formed in subsequent manufacturing steps. This is done following a lithographic stage followed by an etching step carried out to define the graphene channel(s). The graphene channel(s) are defined through semiconductor lithographic techniques over the graphene layer(s), which can be patterned, for example following standard lithographic techniques. Non-limiting examples of semiconductor lithographic techniques that can be used for patterning the graphene layer(s) are X-ray lithography, electron-beam lithography, focused ion beam lithography, optical projection lithography, electron and ion projection lithography, nanoimprint lithography, proximity probe lithography, and near-field optical lithography. The patterns of the graphene channel(s) to be applied have been previously designed with computer-aided techniques, such as CAD software or the like.

Lithography uses for example light or electrons to transfer a geometric pattern from a photomask (not shown) to a light-sensitive chemical resist (also called photoresist) 103, on the substrate (in this case, sacrificial layer 102 op top of graphene layer 101). The photoresist 103 deposited on the sacrificial layer 102 is shown in Figure 3B. The photoresist 103 may be made of a polymeric material, such as PMMA, or of any other conventional resin. The photoresist 103 does not damage the graphene layer 101 thanks to the sacrificial layer 102 protecting the graphene. In other words, a light-sensitive chemical resist 103 is first disposed on the sacrificial layer 102 on top of the graphene layer 101, and then the pattern of the photomask is exposed to be transferred to the graphene layer(s).

Etching stages carried out to define the graphene channel(s) are shown in Figures 4A, 4B & 5. Etching involves forming a multilayer etch mask (for example a photoresist) 103, etching the graphene layer(s) and removing (stripping, for example) the multilayer etch mask 103. Techniques for forming an etching mask are known to those skilled in the art and thus are not described in more detail herein. The etching step may be a dry etching step via, for example, RIE, DRIE or plasma ashing, or a wet etching step. In sum, the mask 103 formed over the graphene layer(s) is used to etch away unwanted areas of the graphene layer(s), and an etch is then used to pattern the graphene and thereby define the channel(s). After etching, the mask 103 is removed following a conventional suitable technique. The pattern of the graphene channel(s) is thus transferred.

The lithographic and etching process can be done in different ways. In certain embodiments, the removal of the sacrificial layer 102 to expose the graphene may be done following the stages shown in Figures 4A & 4B. In other embodiments it may be done as shown in Figure 5. In any case, the result is illustrated in Figure 6, showing a stack formed by the substrate 100, the graphene layer 101' having the pattern channel(s) and the sacrificial layer 102' on top of the graphene layer 101'.

In certain embodiments, a lithographic and etching process as depicted in Figures 4A-4B is used to define the graphene channel(s). In a first stage, shown in Figure 4A, a wet etching technique is used to dissolve the area of sacrificial layer 102 not covered by resist layer 103, exposing the graphene layer(s) 101 underneath. A wet etching which attacks the sacrificial layer 102, but not the resist layer 103, is applied. In a second stage, shown in Figure 4B, a dry etching technique is used to remove the area of graphene layer(s) 101 not covered by the stack formed by the sacrificial layer 102' and resist layer 103'.

Then, the resist layer 103' (i.e. photoresist) is removed, leaving a stack as shown in Figure 6. Removal of the photoresist 103' is done in a conventional way, such as with solvents. A solvent suitable to remove the photoresist 103' (such as a resin, like PMMA) but not the sacrificial layer 102' is used.

In certain embodiments, an alternative lithographic and etching process as depicted in Figure 5 is used to define the graphene channel(s). In this case, a dry etching technique is used to remove both the area of sacrificial layer 102 and the graphene layer(s) 101 underneath not covered by resist layer 103'. A part of the resist layer 103 of Figure 3B has previously been removed by a lithographic step. This dry etching is preferred to the combined wet and dry etching of Figures 4A-4B because the dry etching is a much cleaner process than the wet etching process, in which an extra step of drying and likely another post-drying cleaning step, are required.

Then, the resist layer 103' (i.e. photoresist) is removed in a conventional way, as already explained, leaving a stack as shown in Figure 6. The graphene channel(s) is(are) thus defined.

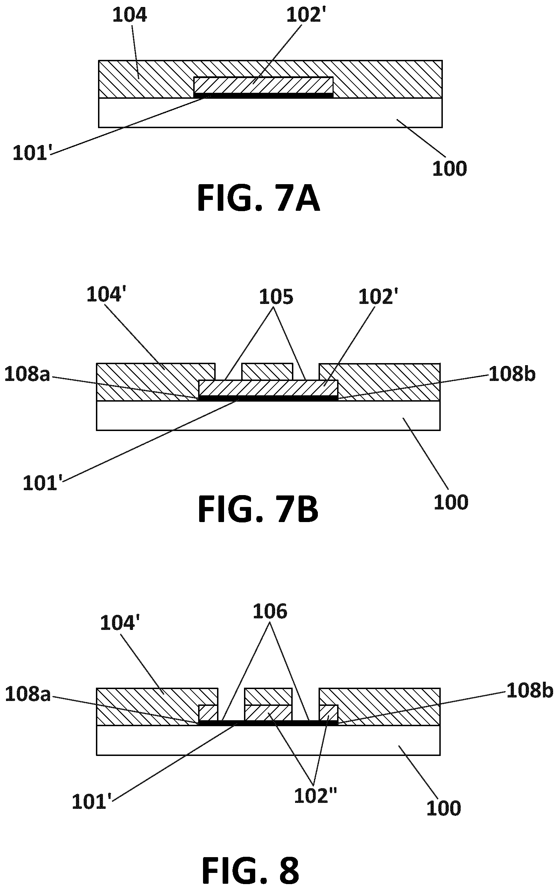

Once the graphene channel(s) are defined on the graphene layer 101' without damaging or contaminating the graphene due to the sacrificial layer 102', which protects the graphene from any contamination, a lithographic process is carried out to define the contact area on which metal will be subsequently deposited. This lithographic process is illustrated in Figures 7A-7B. The metallization (metal deposition) can be made using a conventional lift-off process. The lift-off process is an additive technique in which a pattern of a target material (metal) is created on a surface using a mask material (e.g. resist, such as photoresist). Lift-off can be done by performing conventional photolithography before performing a metal deposition and then removing the applied photoresist, for example with a chemical etch. The contact area defined by this process is shown in Figure 7B.

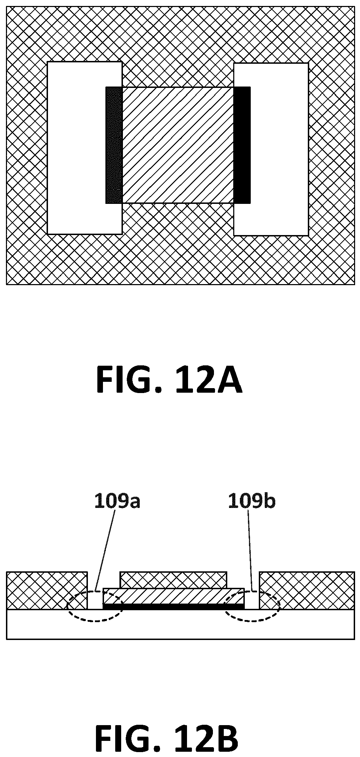

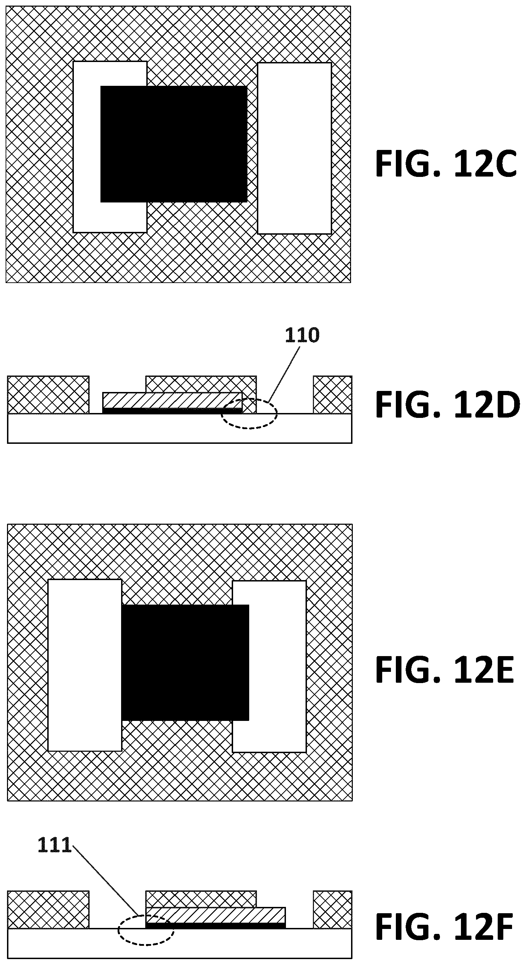

The contact area 105 is an area (or several areas) in contact with the graphene layer 101', in which an electric conductive material will be deposited, so that electric contacts are created. These contacts are defined through the sacrificial layer 102' which protects the graphene layer 101'. As a matter of example, when the graphene device is a transistor, such as a GFET, electric contacts may be drain and source contacts and the gate contact can be a back contact through the substrate 100 (not shown). In embodiments of the invention, the contact area defined by means of a lithographic process is a contact area defined within the graphene channel as shown in Figure 7B, and not at the edge or edges (lateral sides) 108a, 108b of the graphene channel. In the context of the present disclosure, a contact built within the graphene channel is a contact which is either surrounded by graphene along the whole perimeter of the lower surface or base of the contact (edge contact) or deposited on the upper surface of the graphene channel (top contact) but not at the lateral side of the graphene channel (this lateral side defining the border between the graphene channel and the substrate). For example, a contact built within the graphene channel does not extend beyond the graphene layer, for example occupying portions of the substrate not occupied by the graphene layer. In other words, contacts defined within the graphene channel are contacts not colliding with or overpassing the lateral sides of the graphene channel. It is noted that contacts within the graphene channel can be either top contacts (when they are deposited on the upper surface of the graphene channel) or edge contacts (when they are in contact with the graphene channel only at the outer perimeter of the contact and not at the lower surface thereof; in other words, edge contacts are in contact with the graphene channel only along the thickness (height) of the graphene channel). In other words, the defined contact area does not have a portion of contact area at the lateral sides of the graphene channel as shown for example in Figures 12A-12B. A contact area is within a graphene channel when, considering a cross-section view of the graphene layer 102', the contact area does not touch or overlap the lateral sides 108a, 108b of the graphene layer 102'. The contact area or areas are configured to subsequently receive a metal deposition to act as electric contact.

The metal patterning process is as follows. As shown in Figure 7A, a mask layer or resist layer (e.g. photoresist) 104 is deposited on the surface of the substrate 100 and on the stack formed by the graphene layer 101' covered by sacrificial layer 102'. This resist 104 will be used in defining electric contacts (for example source and drain contacts, when the device is a GFET) of the graphene channel(s). Techniques for forming resist 104 are known to those skilled in the art and thus are not further described herein. A conventional photoresist, like the one used in previous lithographic stages, may be used. The thickness of the mask layer 104 may be between 50 nm (nanometer, 10⁻⁹ m) and 500 µm (microns, 10⁻⁶ m). An inverse pattern is created in the mask layer 104, for example by exposing and developing the photoresist. This way, a geometric pattern representing the metal to be deposited is transferred from a photomask to the light-sensitive mask material 104. The photoresist 104 is then removed in the areas where the metal is to be located (contact areas 105), creating an inverse pattern, as shown in Figure 7B. In other words, by removing (for example, developing) openings through the mask layer 104, later the target material (metal) can reach the surface of the graphene layer 101' in those regions, where the final pattern is to be created. The graphene layer 101' is not affected by the developing of the mask layer 104 because it is protected by sacrificial layer 102'. Figure 7B shows the remaining mask layer 104' after the inverse pattern is created and the openings on contact area 105 are developed. Depending on the mask material, various methods can be used, such as Extreme ultraviolet lithography (EUVL), Electron beam lithography (EBL), contact lithography, projection lithography, immersion lithography, nano imprint lithography or X-ray lithography.

Finally, an etching process is carried out, such as a wet etching process, on the sacrificial layer 102', to expose the graphene area 106 to be contacted. Reference sign 106 refers to the area or portion of the graphene layer 101' within which the metal will be deposited. The remaining portions of sacrificial layer 102" are also shown. This is shown in Figure 8. The metal contact or contacts can be top contacts or edge contacts, but they are always contacts within the graphene channel. Contacts are edge contacts (not shown) when an additional etching process is applied (for example, plasma etching), to open an atomic-size groove or slot in the graphene channel prior to metal deposition. Graphene area(s) 106 is(are) exposed for metal contact formation. Subsequently, metal can be deposited on the graphene layer 101', filling the hollows defined over the exposed graphene areas 106. Although Figures 7B and 8 show two contact areas 105, 106, the invention is not limited to any number of contact areas, thus defining a plurality of contact areas.

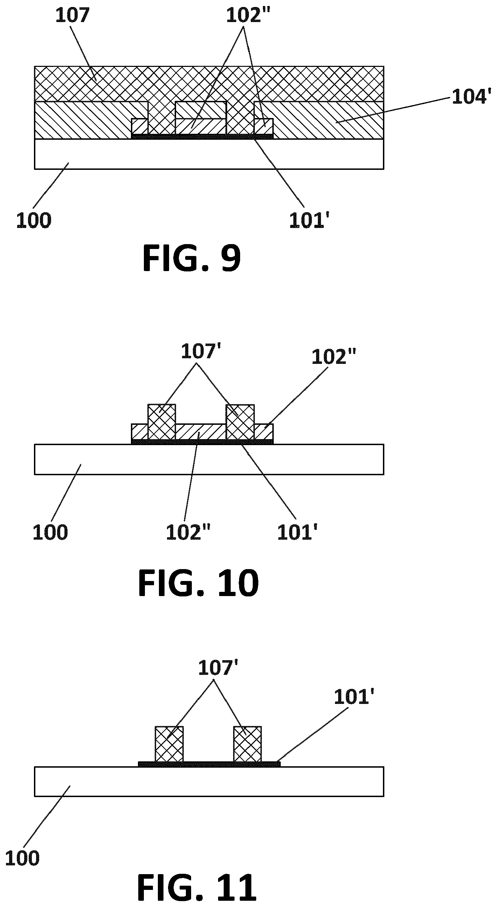

Metal contacts are then deposited, following the stages shown in Figures 9-11. The graphene device is thus metallized, for example following a top contact approach, such as via evaporation of metal, such as thermal evaporation or e-beam evaporation, or by electro-deposition, or by electroplating. Alternatively, an edge contact approach can be used, which requires a previous stage of etching process. Preferably, a non-aggressive deposition technique is used for applying the metallization 107 on the graphene channel 101' (in particular, on exposed graphene areas 106 and on the mask layer 104'), so that the graphene channel 101' is not damaged. In particular, any deposition technique which does not use plasma is preferably used. Non-limiting examples of metals or metallic compounds used in the deposition process are: Titanium (Ti), Nickel (Ni), Gold (Au), Palladium (Pd), Cobalt (Co), Chromium (Cr), Aluminum (Al), Tungsten (W), TaN, Silicon (Si), doped Silicon (doped Si), poly-silicon (poly-Si), Cobalt monosilicide (CoSi), Platinum (Pt), Copper (Cu), Silver (Ag), Lead (Pb), Iron (Fe), Cobalt-Iron (CoFe), Zinc (Zn), Scandium (Sc), Bismuth (Bi), Niobium (Nb), Titanium Nitride (TiN) and combinations/alloys of these materials or compounds.

At this stage, the metallic layer 107, usually a thin metal layer, is deposited over the whole area of the die, covering the mask layer 104' and the exposed graphene areas 106. The thickness of the metal layer 107 is between 0.1 and 1000nm, such as between 1 and 100nm. In other words, this layer 107 covers, in addition to the exposed graphene areas, the remaining resist 104'. Subsequently, when the mask layer 104' (e.g. resist or photoresist) is washed away (for example, photoresist in a solvent), the metal on the top of the mask layer 104' is lifted-off and washed together with the mask layer 104' below. After the lift-off, the deposited material (metal) 107' remains only in the regions where it has a direct contact with the graphene channel 101' (exposed graphene areas 106). This is shown in Figure 10. In sum, only the metallic material that was in the holes having direct contact with the underlying layer (graphene contact areas 106) stays. The thickness of the one or more metallic contacts 104' is in the range of between 0.1 and 1000nm, such as between 1 and 100 nanometers. This mild deposition of metal does not damage the graphene because it does not require the use of plasma, and ensures good contact resistance, which is a physical parameter used to characterize the quality of an electrical contact and its electron injection into a device. In the embodiment shown in Figure 10, two metallic structures 104' have been created. However, the invention is not limited to two metallic structures. Depending on the final application of the graphene device, a single metallic structure may be created, or more than two metallic structures can be created. For example, when two metallic contacts are obtained, one metallic structure enables a subsequent connection of the graphene device to an electric negative pole (of, for example, a voltage source, not shown) and another metallic structure enables a subsequent connection of the graphene device to an electric positive pole (of, for example, the not shown voltage source). The metallization process of the present invention could alternatively involve a single metallic structure 104' if the graphene device requires a single electrical connection to a socket, PCB, or the like, for example in the case of a graphene device being a hybrid device. In sum, the deposition of metal has resulted in at least one metallic path 104' in contact with the graphene channel 101'.

Optionally, the encapsulation (sacrificial layer 102") can be removed. For example, a final wet etching process can be done to remove the sacrificial layer 102", in such a way that the graphene channel 101' remains exposed. This is shown in Figure 11. This may be necessary in certain applications, such as when the graphene device works as a biosensor.

The proposed method prevents the major cause of contamination in the graphene device, typically introduced in the form of polymeric contamination, mainly due to the resists in the patterning process. This is achieved because the graphene layer(s) and channel(s) is/are always protected or passivated by a non-contaminating dielectric made of an inorganic oxide. Thus, the quality of the metallic contact is increased (for example, the contact resistance is reduced), resulting in improved carrier injection and electron mobility.

In addition, because the metallic contacts 107' (such as drain and source contacts when the device is a GFET) are defined and built within the graphene channel, instead of at the lateral sides 108a, 108b thereof (in lateral areas of the graphene when a cross-section view is considered, delimiting with, for example, the substrate) as is the case in standard contact schemes, as shown in Figures 12A & 12B, the alignment tolerance is relaxed, because the edges of the graphene channel can be extended as much as needed without altering the actual length or width of the device. This also avoids large edge exposure of the photoresist developers that can cause detachment of the graphene film, deteriorating the quality of the contact. In sum, this contact geometry prevents misalignment problems and graphene detachment). Figures 12A and 12B are shown in comparison with the stack shown in Figure 8 (graphene area 106 exposed to be contacted). The stack of Figures 12A-12B has followed, regarding the creation of contact areas (to receive metallic deposition), a standard contact approach, in which the contact areas 109a, 109b are defined at the lateral sides of the graphene channel. As shown in Figures 12C-12D, a small misalignment 110 causes bad graphene/contact overlap, that is to say, a non-contacted device. Furthermore, as shown in Figures 12E-12F, it implies a larger area exposed to the photoresist developer, causing detachment and bad graphene/contact overlap area 111, that is to say, non-contacted graphene device.

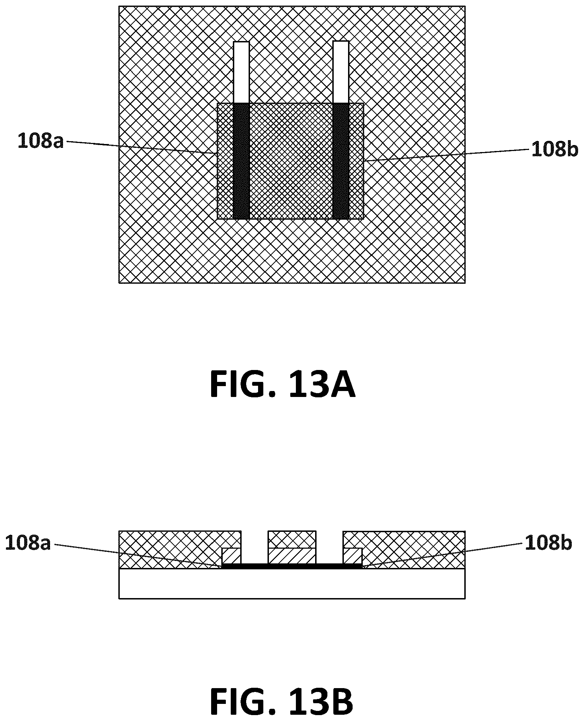

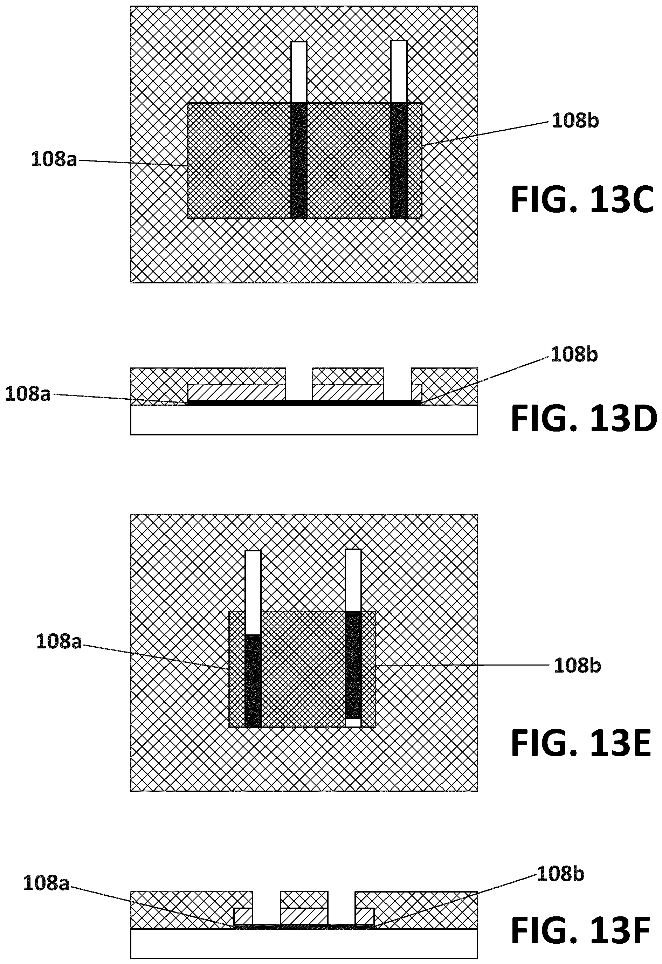

By contrast, the proposed contact approach (Figures 13A-13F) in which the metal contacts are defined within the graphene channel and not at the edges 108a 108b thereof, overcomes these problems. The channel length can be increased as much as the alignment needs without sacrificing neither channel length nor graphene/contact overlap area, as shown in Figures 13C-13D. The contact is therefore always good. Furthermore, the edges and surface exposed to the photoresist developer is minimized, thus detachment is minimized and good graphene/contact overlap area is obtained, as shown in Figures 13E-13F. The contact is thus always good.

In this text, the term "comprises" and its derivations (such as "comprising", etc.) should not be understood in an excluding sense, that is, these terms should not be interpreted as excluding the possibility that what is described and defined may include further elements, steps, etc.

In the context of the present invention, the term "approximately" and terms of its family (such as "approximate", etc.) should be understood as indicating values very near to those which accompany the aforementioned term. That is to say, a deviation within reasonable limits from an exact value should be accepted, because a skilled person in the art will understand that such a deviation from the values indicated is inevitable due to measurement inaccuracies, machinery tolerances, etc. The same applies to the terms "about" and "around" and "substantially".

The invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

## Claims

1. A method of fabricating a graphene-based solid-state device, the method comprising:
disposing a graphene layer (101) on a substrate (100);
depositing a sacrificial layer (102) on the graphene layer (101), the sacrificial layer (102) being made of a non-polymeric dielectric material;
patterning the graphene layer (101) by defining at least one channel region, wherein the patterning is done by applying a lithographic process followed by an etching process using a resist layer (103), thus obtaining a patterned graphene layer (101'), wherein the graphene layer (101') has been protected against contamination from the resist layer (103) by the sacrificial layer (102);
patterning on the graphene layer (101') a geometry of at least one metallic contact to be deposited;
depositing the at least one metallic contact (107') on the graphene layer (101').

2. The method of claim 1, wherein the substrate (100) is made of a material comprising at least one of the following: glass, quartz, silicon (Si), germanium (Ge), silicon carbide, silicon oxide, gallium arsenide, SiO2/Si, SiO2, Al2O3, ZrO2, HfO2, HfSiO4, Ta2O5, La2O3, LaAIO3, Nb2O5, TiO2, BaTiO3, SrTiO3, CaCu3Ti4O12, Si3N4, ZrSiO4, Y2O3, CaO, MgO, BaO, WO3, MoO3, Sc2O3, Li2O and SrO.

3. The method of either claim 1 or 2, wherein the substrate (100) is formed by two layers, wherein one of the layers is made of one of silicon, silicon oxide, glass, quartz and polymeric material; and the other layer is made of one of glass, quartz, Si, SiO2/Si, SiO2, Al2O3, ZrO2, HfO2, HfSiO4, Ta2O5, La2O3, LaAIO3, Nb2O5, TiO2, BaTiO3, SrTiO3, CaCu3Ti4O12, Si3N4, ZrSiO4, Y2O3, CaO, MgO, BaO, WO3, MoO3, Sc2O3, Li2O and SrO.

4. The method of any one of claims 1-3, wherein prior to disposing the at least one graphene layer (101) on the substrate (100), the substrate (100) is cleaned to remove impurities and increase hydrophilicity.

5. The method of any one of claims 1-4, wherein the at least one graphene layer (101) is deposited, transferred or grown on the substrate (100).

6. The method of any one of claims 1-5, wherein the sacrificial layer (102) is deposited using atomic layer deposition (ALD), chemical vapor deposition (CVP), atomic layer deposition (ALD), chemical vapor deposition (CVD), Vapour Phase Epitaxy, sputtering or Molecular Beam Epitaxy (MBE).

7. The method of any one of claims 1-6, wherein the thickness of the sacrificial layer (102) is selected to be between 1Å and 100µm.

8. The method of any one of claims 1-7, wherein the non-polymeric dielectric material of which the sacrificial layer (102) is made is an inorganic oxide.

9. The method of claim 8, wherein the inorganic oxide is selected from the following: SiO2, Al2O3, ZrO2, HfO2, HfSiO4, Ta2O5, La2O3, LaAIO3, Nb2O5, TiO2, BaTiO3, SrTiO3, CaCu3Ti4O12, GaN, TaN, Si3N4, ZrSiO4, Y2O3, CaO, MgO, BaO, WO3, MoO3, Sc2O3, Li2O and SrO.

10. The method of any one of claims 1-9, wherein the patterning of the at least one graphene channel (101') is done as follows:
applying a wet etching technique to dissolve the area of the sacrificial layer (102) not covered by resist layer (103), exposing the graphene layer(s) (101) underneath;
applying a dry etching technique to remove the area of graphene layer(s) (101) not covered by the stack formed by sacrificial layer (102) and resist layer (103).

11. The method of any one of claims 1-9, wherein the patterning of the at least one graphene channel (101) is done as follows:
applying a dry etching technique to remove both the area of the sacrificial layer (102) and the graphene layer(s) (101) underneath not covered by resist layer (103).

12. The method of any one of claims 1-11, wherein the patterning on the graphene layer (101) of the geometry of the at least one metallic contact to be deposited is done as follows:
depositing a mask layer on the graphene layer (101'),
creating an inverse pattern in the mask layer by removing the mask layer in the selected areas where the metal is to be deposited, and leaving the mask layer in the regions to be protected.

13. The method of any one of claims 1-12, wherein the at least one metallic contact (107') is deposited as follows:
applying a metallic layer (107),
lifting off the remaining mask layer (104), thus removing the metal deposited on the remaining mask layer (104'), so that the at least one metallic contact (107') remains only in the regions where metal has a direct contact with the graphene layer (101).

14. The method of any one of claims 1-13, wherein the geometry of the at least one metallic contact to be deposited is patterned within the graphene channel and separate from the lateral sides (108a, 108b) of the graphene channel.

15. A graphene-based solid-state device, comprising:
a substrate (100);
a graphene layer (101) disposed on the substrate (100), the graphene layer (101) defining at least one graphene channel; the graphene layer (101) being protected by a sacrificial layer (102) made of a non-polymeric dielectric material;
at least one metallic contact (107') in contact with the graphene channel.
